# EUROPEAN PATENT SPECIFICATION

(11) **EP 4 550 422 B1**
(45) Date of publication and mention of the grant of the patent: **14.10.2026**
(21) Application number: 24168351.5
(22) Date of filing: 04.04.2024
(51) Int. Cl.: H10D 30/47, H10D 64/00, H10D 30/01, H10D 62/17, H10D 62/85, H10D 64/27

(54) **HIGH ELECTRON MOBILITY TRANSISTOR WITH REGROWN BARRIER STRUCTURE**
TRANSISTOR MIT HOHER ELEKTRONENMOBILITÄT MIT WIEDERAUFGEWACHSENER BARRIERENSTRUKTUR
TRANSISTOR À HAUTE MOBILITÉ D'ÉLECTRONS AVEC STRUCTURE DE BARRIÈRE FORMÉE PAR RECROISSANCE

(30) Priority: 30.10.2023 US 202318385255
(43) Date of publication of application: 07.05.2025
(73) Proprietor: GlobalFoundries U.S. Inc., Malta, NY 12020 (US)
(72) Inventor: BENTLEY, Steven J., Malta, NY 12020 (US); SHARMA, Santosh, Austin, TX 78732 (US); KANTAROVSKY, Johnatan A., Essex Junction, VT 05452 (US); LEVY, Mark D., Essex Junction, VT 05452 (US); ZIERAK, Michael J., Essex Junction, VT 05452 (US)
(74) Representative: Lambacher, Michael

(56) References cited:
- CN-A- 101 414 625
- JP-B2- 6 335 444
- US-A1- 2020 335 616
- US-A1- 2022 165 853

## Description

### BACKGROUND

The present invention relates to to high electron mobility transistors and methods of manufacture.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material families are GaN or GaAs, although other materials can be used, dependent on the application of the device.

Due to the higher critical field and switching figures of merit of the GaN materials system, GaN HEMT devices typically have a higher electric-field strength than silicon MOSFETS, providing substantial performance improvements in, for example, on-resistance and breakdown voltage, while offering fast switching speed, amongst other important parameters. Since these properties result in fundamentally higher system efficiency, HEMTs may be used in diverse power management applications, such as AC-DC and DC-DC conversion in the consumer or automotive space. In RF applications, they may be used in high frequency power amplifiers, low noise amplifiers or switches in such applications as cell phones, satellite or receivers or radar equipment.

From US 2020/335616 A1 HEMT structures are known comprising a T-shaped recessed gate structure. Further, JP 6 335444 B2 describes HEMT structures comprising a T-shaped gate structure and a field plate over the T-shaped gate structure. Further, US 2022/165853 A1 describes a trench gate HEMT comprising a MIS gate electrode and hence, a thinner barrier under the gate as compared to the region adjacent to the gate. Furthermore, a field plate that is arranged symmetrically around the gate is disclosed. However, no gate structure is shown and therefore, it is not shown that the field plate extends over a gate structure. Further, CN 101 414 625 A describes a HEMT structure comprising a gate field plate, a drain field plate, and a plurality of equally sized floating field plates between the gate field plate and the drain field plate. Additionally, a barrier that is thinner in the gate region and thicker in the non-gate region is shown.

### SUMMARY

The invention is defined by the appended set of claims.

### BRIEF DESCRIPTION OF THE DRAWINGS

The present disclosure is described in the detailed description which follows, in reference to the noted plurality of drawings by way of non-limiting examples of exemplary embodiments of the present disclosure. The term disclosure is to be taken literally, with the invention being defined by the appended claims only.
FIG. 1 shows a device in accordance with aspects of the present disclosure. The embodiment does not fall under the scope of the claims.
FIG. 2 shows a device according to the invention.
FIG. 3 shows a device in accordance with further aspects of the present disclosure. The embodiment does not fall under the scope of the claims.
FIGS. 4A-4D show fabrication processes for manufacturing the HEMT device of FIG. 2 according to the invention.

### DETAILED DESCRIPTION

The present disclosure relates to semiconductor structures and, more particularly, to high electron mobility transistors (HEMT) and methods of manufacture. More specifically, the present disclosure relates to a GaN HEMT with a stepped-thickness barrier layer structure adjacent to the gate structure. Advantageously, the HEMT described herein provides improved electric field control in addition to lower Ron for enhanced performance and reliability.

In more specific embodiments, the structure comprises a GaN HEMT with a gate structure, source/drain regions adjacent to the gate structure and a field plate. A barrier layer, e.g., AlGaN, is epitaxially grown adjacent to the gate structure, and has a substantially step change in thickness adjacent to the gate. In embodiments, the change can be a curve or tapered profile or a stepped feature. The thicker region may be symmetrically spaced from the gate structure. In some embodiments, the gate structure may include a p-doped GaN layer in addition to one or more gate metals. The barrier layer may be symmetrically self-aligned to the gate structure and, e.g., separated from the gate structure by equal distances on both sides. The thicker region of the barrier layer is spaced away from the gate structure and may have a different composition to the barrier layer under the gate structure.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

In addition, the present disclosure utilizes epitaxy processes as is known in the art. Epitaxy refers to a type of crystal growth or material deposition in which new crystalline layers are formed with one or more well-defined orientations with respect to the crystalline seed layer. For most epitaxial growths, the new layer is usually crystalline and each crystallographic domain of the overlayer has a well-defined orientation relative to the substrate crystal structure. Epitaxy can involve single-crystal structures. An epitaxial layer can be doped during deposition by adding a flow of impurities, such as arsine, phosphine, or via the use of metal-organic precursors. Dopants in the source may diffuse into the epitaxial layer. The concentration of impurity in the gas/vapor phase determines its concentration in the deposited film. Additionally, the high temperatures at which epitaxy is performed may allow dopants to diffuse into the growing layer from other layers in the wafer (out-diffusion).

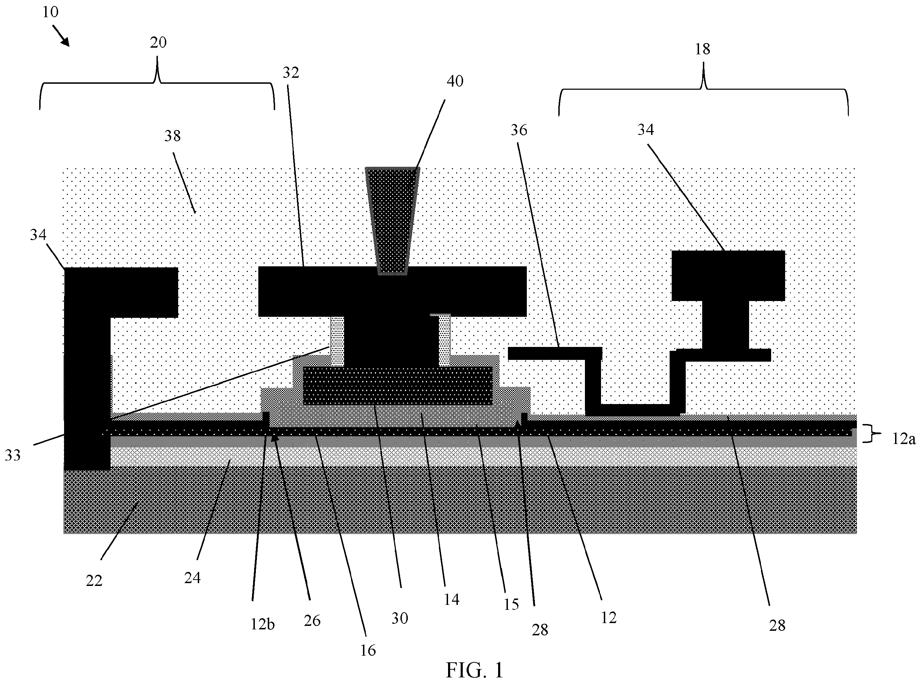

FIG. 1 shows a device and respective fabrication processes in accordance with aspects of the present disclosure and not covered by the scope of the claims. In embodiments, the device 10 may be a HEMT comprising a raised barrier layer 12 self-aligned to and surrounding a gate structure 14 within a drain region 18 and, optionally, within a source region 20. In embodiments, the raised barrier layer 12 may be formed over a barrier layer 16. The combination of the barrier layers 12, 16 adjacent to the gate structure 14 in the drain region 18 may form a thicker region 12a compared to only the barrier layer 16 under the gate structure 14. The thicker region 12a may act to reduce channel resistance between the gate structure 14 and the drain region 18. For example, the increased volume of semiconductor material at the thicker region 12a allows an increase in carrier concentration of 2DEG (e.g., 2-dimensional electron gas) in the channel region of the device under the thicker region 12a, effectively reducing the resistance of the channel layer 15.

In more specific embodiments, the device 10 of FIG. 1 includes a semiconductor substrate 22 with a buffer layer 24 over the semiconductor substrate 22, a channel layer 15 and the barrier layers 12, 16 over the buffer layer 24. The gate structure 14 may be formed over the barrier layer 16 and between islands of the barrier layer 12. In embodiments, the barrier layer 12 may be a self-aligned barrier layer formed over the barrier layer 16 outside of the gate structure 14 (e.g., adjacent to the gate structure 14 in the drain region 18 and, optionally, the source region 20); whereas the barrier layer 16 is both adjacent to and underneath the gate structure 14. In this way, the combination of the barrier layers 12, 16 forms a thicker region 12a in the drain region 18 and, optionally, the source region 20 of the device 10.

In embodiments, the semiconductor substrate 22 may be, e.g., Si, with a single crystalline orientation. For example, in preferred embodiments, the semiconductor substrate 22 comprises p-type Si material with a suitable crystal orientation, e.g., (111). In alternative embodiments, the semiconductor substrate 22 may any suitable material including, but not limited to, SiC, SiGe, SiGeC, GaAs, InAs, InP, Sapphire and other III/V or II/VI compound semiconductors, including engineered substrates such as SOI or QST. The buffer layer 24 may be any semiconductor material that acts as a buffer material in a HEMT as is known in the art. For example, the buffer layer 24 may be GaN, AlGaN, or any combination thereof. The gate structure 14 may include one or more layers of GaN or AlGaN, which may be partially p- or n-doped, and may include one or more metallic layers.

In embodiments, the barrier layer 12 may be an epitaxially grown semiconductor material on the barrier layer 16. In embodiments, the barrier layers 12, 16 may both be AlGaN. In alternative embodiments, the barrier layers 12, 16 may be different materials or the same material with different material compositions, e.g., alloy compositions. For example, the barrier layer 16 may be AlₓGa₁₋ₓN and the barrier layer 12 may be Al_{y}Ga_{1-y}N, InₓAl₁₋ₓN, AlN, etc., where x and y comprise the mole fraction of the respective ternary. The thicker region 12a may, for example, have a different Al concentration near the top surface than near a bottom surface, or maybe graded in composition. The AlGaN/GaN layers, e.g., channel layer 15 and barrier layers 12, 16, may result in a conducting 2DEG channel for the HEMT device 10.

The barrier layer 16 may be positioned symmetrically or asymmetrically about the gate structure 14, e.g., adjacent to the gate structure 14 in the drain region 18 and, optionally, in the source region 20. In this way, the combination of the barrier layers 12, 16 in the drain region 18 form a thicker region 12a than the barrier layer 16 under the gate structure 14. In embodiments, the thicker region 12a may also be partially or fully under a field plate 36. The field plate 36 may include steps or variations in the dielectric thickness between it and the dielectric material 28.

In embodiments, the thicker region 12a may be twice as thick as the barrier layer 16, alone, under the gate structure 14; although other dimensions are also contemplated herein depending on the device specifications and desired performance. For example, the barrier layer 16 may be 2 nm to 25 nm, in thickness, scaling to a particular device application; whereas the thicker region 12a, e.g., combination of the barrier layers 12, 16, may range from about 5% to 100% greater in thickness than the barrier layer 16, alone. As already disclosed herein, the thicker region 12a may act to reduce channel resistance between the gate structure 14 and the drain region 18, i.e., allows an increase in carrier concentration of 2DEG which effectively reduces the resistance of the channel layer 15.

In further embodiments, the barrier layer 12 may be separated or remote from the gate structure 14 by a gap 26 filled with a dielectric material 28. In embodiments, the gap 26 may be symmetrical or asymmetrical positioned about the gate structure 24. For example, the gap 26 between the barrier layer 12, e.g., AlGaN, and the gate structure 14, e.g., pGaN and metal, can be modulated by use of a lithographic mask during a spacer etch process. The mask can also allow placement of edge 12b of the barrier layer 12 at an arbitrary distance away from the gate structure 14, while another side remains self-aligned to the gate structure 14. In embodiments, this could be done on either the source or drain side of the gate, or in the third dimension (in the device width direction). Further, such patterning could also allow "islands" of thicker barrier to be formed arbitrarily over the surface of barrier 16.

In embodiments, the dielectric material 28 may be provided over the barrier layer 12 and in the gap 26 between the barrier layer 12 and the gate structure 14. The dielectric material 28 may also be provided over the gate structure 14 and a gate metal 30 connecting to and over the gate structure 14. The dielectric material 28 may be aluminum oxide (e.g., Al₂O₃) or silicon oxide (e.g., SiO₂) or silicon nitride (e.g., Si₃N₄) or combinations thereof, and may be deposited by, for example, an atomic layer deposition (ALD), physical vapor deposition (PVD), or chemical vapor deposition (CVD) process.

The gate metal 30 may be formed in direct contact with the gate structure 14 at a first level of the device. Additional gate metal 32 may be formed over and in direct contact with the gate metal 30. The gate metal 32 may include spacers 33 on its vertical sidewalls, which may isolate the gate metal 32 from the field plate 36. A metal material 34 may also be formed to the source region 20 and drain region 18 (e.g., source contact and drain contact), with the drain region 18 including the field plate 36 partially or completely over the thicker region 12a. In embodiments, the gate metals 30, 32, and metal material 34 may be any appropriate conductive material, e.g., tungsten or aluminum with a TiN or TaN liner. The field plate 36 may be TiN, for example. The spacers 33 may be any oxide material, nitride material or combinations thereof.

The field plate 36 may be formed over and in contact with the dielectric material 28, extending over the thicker region 12a of the combination of barrier layers 12, 16. Moreover, in embodiments, the field plate 36 may be electrically connected to the source contact 34 and potentially another field plate may be connected to the drain region 18. In embodiments, the field plate structure 36 (which may be part of a larger multi-step metallic field plate structure) may have steps at multiple heights spaced vertically from the surface of the barrier layers 12a. In embodiments, the field plate structure 36 may connect to the same metals that comprise the source/drain ohmic metals (e.g., metal structure 34), and/or gate metal 32 in order to form this larger multi-step metallic structure. In embodiments, the multi-step metallic field plate structure may straddle the dual thickness barrier layers 12, 16, e.g., AlGaN.

The gate metals 30, 32, metal material 34, via interconnect structures 40 and field plate 36 may be formed within different layers of the interlevel dielectric 38 using conventional lithography, etching and deposition methods as is known in the art. By way of example, a resist formed over the insulator material 38 is exposed to energy (light) and developed utilizing a conventional resist developer to form a pattern (opening). An etching process with a selective chemistry, e.g., reactive ion etching (RIE), will be used to transfer the pattern from the patterned photoresist layer to the insulator material 38 to form one or more trenches in the insulator material 38 through the openings of the resist. Following the resist removal by a conventional oxygen ashing process or other known stripants, conductive material can be deposited by any conventional deposition processes, e.g., chemical vapor deposition (CVD) processes. Any residual material on the surface of the insulator material 38 can be removed by conventional chemical mechanical polishing (CMP) processes. The field plate 36, gate metal 32 or Ohmic metal 34 may be similarly patterned to include metal material on the insulator material 38 at certain wiring levels.

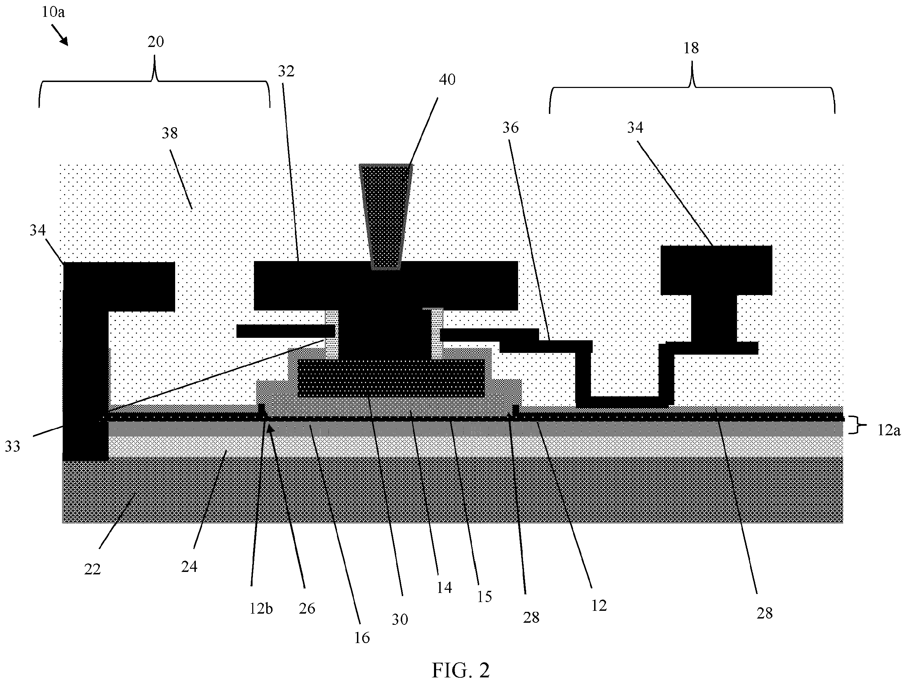

FIG. 2 shows a device according to the invention. The device 10a is a HEMT comprising a self-aligned field plate 36 which surrounds the vertical portion of the metal layer 32 such that field plate metal is present on both the source and drain sides of the gate, e.g., self-aligned field plate. The spacers 33 will isolate the gate metal 32 from the field plate 36. The device 10a also includes the thicker region 12a adjacent to the gate structure 14, with a gap 26 filled with insulator material 28 between the barrier layer 12 and the gate structure 14. The remaining features of the device 10a are similar to the device 10 of FIG. 1.

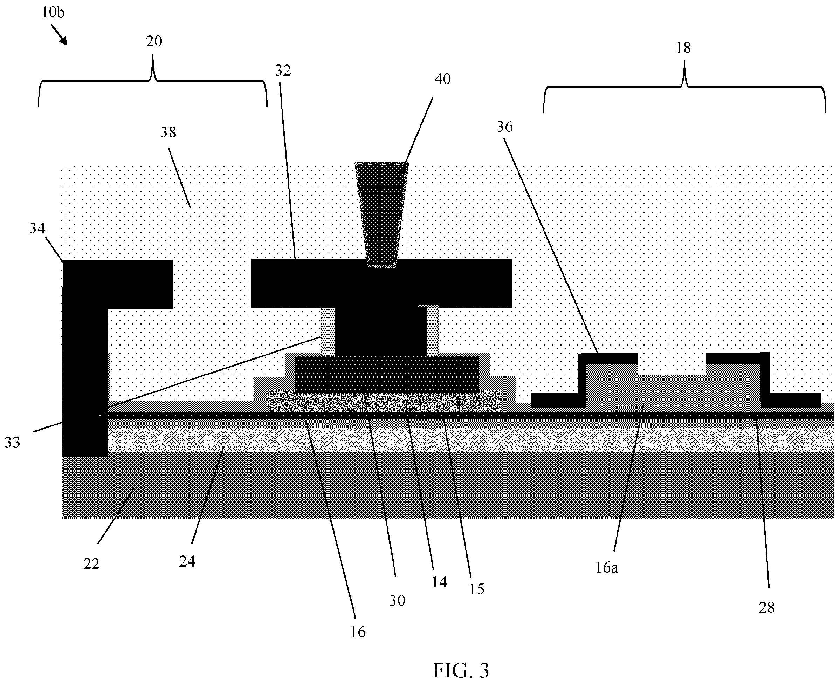

FIG. 3 shows a device in accordance with further aspects of the present disclosure and not covered by the scope of the claims. In embodiments, the device 10b may be a HEMT comprising a field plate 36 adjacent to or near the gate structure 14, at a same device level. The field plate 36 also straddles or extends onto the thicker region 12a adjacent to the gate structure 14. In this configuration, the field plate 36 is not self-aligned, but does extend over the stepped portion 16a, e.g., thicker regions, comprising the barrier layer 16. In other configurations, the field plate may be self-aligned to the gate as shown in Fig 2, or may have similar steps or electrical connections in some portions as shown in Fig 1. The remaining features of the device 10a are similar to the device 10 of FIG. 1.

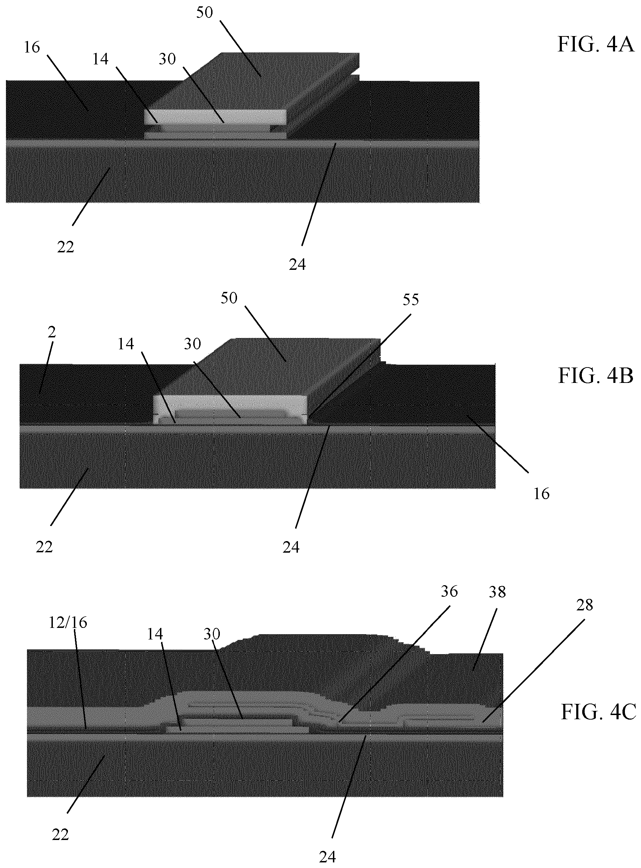

FIGS. 4A-4D show fabrication processes for manufacturing the HEMT device of FIG. 2, according to the invention. Specifically, FIG. 4A shows the buffer layer 24 formed over the semiconductor substrate 22 and the barrier layer 16 formed over the buffer layer 24. In embodiments, the buffer layer 24 and the barrier layer 16 may be formed by conventional deposition processes including, for example, an epitaxial growth process.

Still referring to FIG. 4A, the gate structure 14 is formed over the barrier layer 16. The gate structure 14 can be formed by an in-situ doped epitaxial growth process, e.g., p-doped GaN, followed by a patterning process. The gate metal 30 may be formed over the gate structure 14 by a conventional deposition process, e.g., chemical vapor deposition, followed by a conventional patterning process using hardmask 50, which may, for example, be a dielectric material. In other embodiments, the gate metal 30 may not be present, and may be deposited at a later stage. In embodiments, the patterning processes may be conventional lithography and etching processes (e.g., RIE or wet anisotropic or isotropic etches).

In FIG. 4B, sidewall spacers 55 are formed on the sides of the gate structure 14. In embodiments, the sidewalls 55 may be formed by a conventional deposition process, e.g., CVD or plasma enhanced CVD (PECVD) as examples. The sidewalls 55 may comprise a sacrificial nitride or oxide material, as an example. Following the deposition process, an etching process can be performed to remove any excessive sidewall material on the barrier layer 16.

In FIG. 4C, the barrier layer 12 may be deposited over the barrier layer 16. In embodiments, the barrier layer 12 may be epitaxially grown over the barrier layer 16, with the sidewall spacers 55 preventing contact between the barrier layer 12 and the gate structure 14. Thereafter, the hardmask 50 and sidewall spacers 55 can be removed to form the gap, followed by the deposition of the dielectric material 28 in the gap and over the barrier layer 12, the gate metal 30 and the gate structure 14. The dielectric material 28 may be AlO₂ or SiO₂ or nitride or combinations thereof, deposited by any known deposition method, e.g., ALD, CVD, PVD, etc.

Still referring to FIG. 4C, the interlevel dielectric material 38 may be deposited on the dielectric material 28. A trench may be formed in the interlevel dielectric material 38 using conventional lithography and etching process, followed by field plate formation. The field plate 36 may be formed by the deposition of a metal material which lines the trench and a surface of the interlevel dielectric material 38. The metal material can be patterned, e.g., etched, to form the field plate 36. In the embodiment of FIG. 2, for example, the field plate 36 is patterned to extend over the gate structure 14, or it may be patterned such that it does not extend over the gate structure 14. In still other embodiments, the field plate 36 may be deposited at a later stage in the flow. Another layer of interlevel dielectric material 38 may be deposited over the field plate 36. The interlevel dielectric materials 38 may be formed by a conventional blanket deposition process, e.g., CVD.

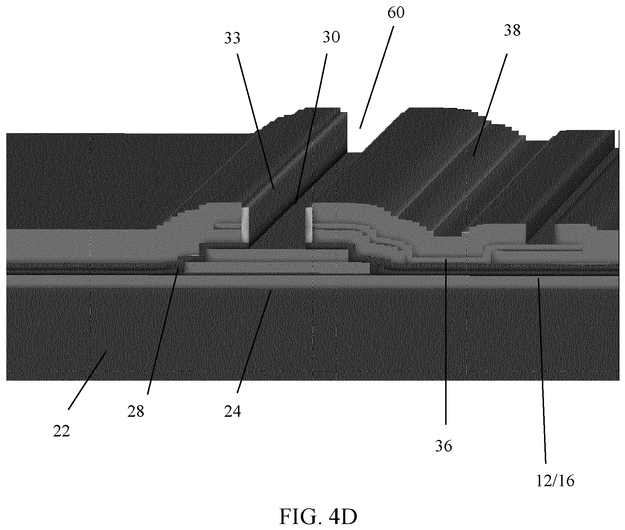

FIG. 4D shows a self-aligned field plate gate process. For example, a trench 60 is formed through the interlevel dielectric material 38, field plate 36 (for the embodiment of FIG. 2) and the dielectric material 28, which exposes the gate metal 30. The spacers 33 may be formed by the deposition of a sidewall material, e.g., nitride, to line the trench 60 and portions of the interlevel dielectric material 28. The sidewall material may be deposited by a conventional deposition method, e.g., CVD, followed by an anisotropic etching process to remove the sidewall material from the bottom of the trench 60 and the interlevel dielectric material 38. The processes may continue with respect to the formation of the metal layers, e.g., gate metal 32, metal material 34, and via interconnect structures 40 as noted with respect to FIG. 1.

The HEMT can be utilized as a single device in discrete applications, may be combined in a single package with several other devices of the same or varying types via co-packaging or multi-chip 3D integration techniques, or may be combined with several other devices in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things. Moreover, GaN devices are increasingly being employed in SoC designs where multiple GaN HEMTs are formed on a single substrate.

The method(s) as described above is used in the fabrication of discrete device or integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes discrete or integrated circuit chips, ranging from toys and other low-end applications to advanced computer products having a display, a keyboard or other input device, and a central processor.

The invention is solely defined by the appended set of claims.

## Claims

1. A high electron mobility transistor, HEMT, comprising:
a gate structure (14) and a gate metal (30, 32) connecting to the gate structure (14);
a first barrier layer (16) under and adjacent to the gate structure (14);
a second barrier layer (12) over the first barrier layer (16) and which is only located in areas adjacent to the gate structure (14), wherein the first barrier layer (16) and the second barrier layer (12) adjacent to the gate structure (14) comprise a thicker region (12a) compared to the first barrier layer (16) under the gate structure (14); and
a field plate (36) above the thicker region (12a),
wherein the field plate (36) extends over the gate structure (14) and surrounds the gate metal (30, 32) and is isolated from the gate metal (30, 32) by a spacer (33) on vertical sidewalls of the gate metal (30, 32).

2. The high electron mobility transistor of claim 1, wherein the field plate (36) has steps at multiple heights spaced vertically from the surface of the barrier layers (12, 16) at the thicker region (12a).

3. The high electron mobility transistor of claim 1 or claim 2, wherein the field plate (36) is over and in contact with a dielectric material (28) that extends over the thicker region (12a).

4. The high electron mobility transistor of one of claims 1 to 3, wherein the field plate (36) is adjacent to the gate structure and further straddles over the thicker region (12a).

5. The high electron mobility transistor of one of claims 1 to 4, wherein the second barrier layer (12) is symmetrically positioned about the gate structure (14), or wherein the second barrier layer (12) is asymmetrically positioned about the gate structure (14).

6. The high electron mobility transistor of one of claims 1 to 5, wherein the first barrier layer (16) and the second barrier layer (12) comprise a same material, or wherein the first barrier layer (16) and the second barrier layer (12) comprise a same material with different alloy compositions, or wherein the first barrier layer (16) and the second barrier layer (12) comprise different materials.

7. The high electron mobility transistor of claim 3, wherein the second barrier layer (12) is spaced away from the gate structure (14) by a gap structure (26) comprising the dielectric material (28).

8. The high electron mobility transistor of one of claims 1 to 7, wherein the field plate (36) connects to a drain contact (34).

9. The high electron mobility transistor of one of claims 1 to 8, wherein the thicker region (12a) of the first barrier layer (16) and the second barrier layer (12) is in the drain region (18).

10. The high electron mobility transistor of claim 9 wherein the first barrier layer (16) and the second barrier layer (12) comprise AlGaN.

11. A method of manufacturing a high electron mobility transistor, HEMT, the method comprising:
forming a gate structure (14) and a gate metal (30, 32) connecting to the gate structure (14);
forming a first barrier layer (16) under and adjacent to the gate structure (14);
forming a second barrier layer (12) over the first barrier layer (16) and which is only located in areas adjacent to the gate structure (14), wherein the first barrier layer (16) and the second barrier layer (12) adjacent to the gate structure (14) comprise a thicker region (12a) compared to the first barrier layer (16) under the gate structure (14); and
forming a field plate (36) above the thicker region (12a), wherein the field plate (36) extends over the gate structure (14) and surrounds the gate metal (30, 32) and is isolated from the gate metal (30, 32) by a spacer (33) on vertical sidewalls of the gate metal (30, 32).

12. The method of claim 11, wherein the second barrier layer (12) is self-aligned to the gate structure (14), and/or wherein the field plate (36) is self-aligned to the gate structure (14).

## Patentansprüche

1. Transistor mit hoher Elektronenbeweglichkeit, HEMT, umfassend:
eine Gate-Struktur (14) und ein Gate-Metall (30, 32), das mit der Gate-Struktur (14) verbunden ist;
eine erste Barriereschicht (16) unter der und benachbart zu der Gate-Struktur (14);
eine zweite Barriereschicht (12) über der ersten Barriereschicht (16) und die sich nur in Bereichen benachbart zu der Gate-Struktur (14) befindet, wobei die erste Barriereschicht (16) und die zweite Barriereschicht (12) benachbart zu der Gate-Struktur (14) eine dickere Region (12a) verglichen mit der ersten Barriereschicht (16) unter der Gate-Struktur (14) umfassen; und
eine Feldplatte (36) über der dickeren Region (12a),
wobei sich die Feldplatte (36) über der Gate-Struktur (14) erstreckt und das Gate-Metall (30, 32) umgibt und von dem Gate-Metall (30, 32) durch einen Spacer (33) an vertikalen Seitenwänden des Gate-Metalls (30, 32) isoliert ist.

2. Transistor mit hoher Elektronenbeweglichkeit nach Anspruch 1, wobei die Feldplatte (36) Stufen in mehreren Höhen, die von der Oberfläche der Barriereschichten (12, 16) vertikal beabstandet sind, an der dickeren Region (12a) aufweist.

3. Transistor mit hoher Elektronenbeweglichkeit nach Anspruch 1 oder Anspruch 2, wobei die Feldplatte (36) über und in Kontakt mit einem dielektrischen Material (28) ist, das sich über der dickeren Region (12a) erstreckt.

4. Transistor mit hoher Elektronenbeweglichkeit nach einem der Ansprüche 1 bis 3, wobei die Feldplatte (36) benachbart zu der Gate-Struktur ist und ferner die dickere Region (12a) überspannt.

5. Transistor mit hoher Elektronenbeweglichkeit nach einem der Ansprüche 1 bis 4, wobei die zweite Barriereschicht (12) symmetrisch um die Gate-Struktur (14) herum positioniert ist, oder wobei die zweite Barriereschicht (12) asymmetrisch um die Gate-Struktur (14) herum positioniert ist.

6. Transistor mit hoher Elektronenbeweglichkeit nach einem der Ansprüche 1 bis 5, wobei die erste Barriereschicht (16) und die zweite Barriereschicht (12) ein gleiches Material umfassen, oder wobei die erste Barriereschicht (16) und die zweite Barriereschicht (12) ein gleiches Material mit unterschiedlichen Legierungszusammensetzungen umfassen, oder wobei die erste Barriereschicht (16) und die zweite Barriereschicht (12) unterschiedliche Materialien umfassen.

7. Transistor mit hoher Elektronenbeweglichkeit nach Anspruch 3, wobei die zweite Barriereschicht (12) von der Gate-Struktur (14) durch eine Spaltstruktur (26) beabstandet ist, die das dielektrische Material (28) umfasst.

8. Transistor mit hoher Elektronenbeweglichkeit nach einem der Ansprüche 1 bis 7, wobei die Feldplatte (36) mit einem Drain-Kontakt (34) verbunden ist.

9. Transistor mit hoher Elektronenbeweglichkeit nach einem der Ansprüche 1 bis 8, wobei die dickere Region (12a) der ersten Barriereschicht (16) und der zweiten Barriereschicht (12) in der Drain-Region (18) ist.

10. Transistor mit hoher Elektronenbeweglichkeit nach Anspruch 9, wobei die erste Barriereschicht (16) und die zweite Barriereschicht (12) AlGaN umfassen.

11. Verfahren zum Herstellen eines Transistors mit hoher Elektronenbeweglichkeit, HEMT, wobei das Verfahren umfasst:
Bilden einer Gate-Struktur (14) und eines Gate-Metalls (30, 32), das mit der Gate-Struktur (14) verbunden ist;
Bilden einer ersten Barriereschicht (16) unter der und benachbart zu der Gate-Struktur (14);
Bilden einer zweiten Barriereschicht (12) über der ersten Barriereschicht (16) und die sich nur in Bereichen benachbart zu der Gate-Struktur (14) befindet, wobei die erste Barriereschicht (16) und die zweite Barriereschicht (12) benachbart zu der Gate-Struktur (14) eine dickere Region (12a) verglichen mit der ersten Barriereschicht (16) unter der Gate-Struktur (14) umfassen; und
Bilden einer Feldplatte (36) über der dickeren Region (12a), wobei sich die Feldplatte (36) über der Gate-Struktur (14) erstreckt und das Gate-Metall (30, 32) umgibt und von dem Gate-Metall (30, 32) durch einen Spacer (33) an vertikalen Seitenwänden des Gate-Metalls (30, 32) isoliert ist.

12. Verfahren nach Anspruch 11, wobei die zweite Barriereschicht (12) selbstausgerichtet an der Gate-Struktur (14) ist, und/oder wobei die Feldplatte (36) selbstausgerichtet an der Gate-Struktur (14) ist.

## Revendications

1. Transistor à haute mobilité d'électrons, HEMT, comprenant :
une structure de grille (14) et un métal de grille (30, 32) connecté à la structure de grille (14) ;
une première couche barrière (16) au-dessous de et adjacente à la structure de grille (14) ;
une deuxième couche barrière (12) au-dessus de la première couche barrière (16) et qui est située seulement dans des zones adjacentes à la structure de grille (14), dans lequel la première couche barrière (16) et la deuxième couche barrière (12) adjacente à la structure de grille (14) comprennent une région plus épaisse (12a) en comparaison avec la première couche barrière (16) au-dessous de la structure de grille (14) ; et
une plaque de champ (36) au-dessus de la région plus épaisse (12a),
dans lequel la plaque de champ (36) s'étend au-dessus de la structure de grille (14) et entoure le métal de grille (30, 32) et est isolée du métal de grille (30, 32) par une entretoise (33) sur des parois latérales verticales du métal de grille (30, 32).

2. Transistor à haute mobilité d'électrons selon la revendication 1, dans lequel la plaque de champ (36) présente des marches à des hauteurs multiples espacées verticalement à partir de la surface des couches barrières (12, 16) au niveau de la région plus épaisse (12a).

3. Transistor à haute mobilité d'électrons selon la revendication 1 ou la revendication 2, dans lequel la plaque de champ (36) se trouve au-dessus de et en contact avec un matériau diélectrique (28) qui s'étend au-dessus de la région plus épaisse (12a).

4. Transistor à haute mobilité d'électrons selon l'une des revendications 1 à 3, dans lequel la plaque de champ (36) est adjacente à la structure de grille et s'étend en outre à cheval au-dessus de la région plus épaisse (12a).

5. Transistor à haute mobilité d'électrons selon l'une des revendications 1 à 4, dans lequel la deuxième couche barrière (12) est positionnée de façon symétrique par rapport à la structure de grille (14), ou dans lequel la deuxième couche barrière (12) est positionnée de façon asymétrique par rapport à la structure de grille (14).

6. Transistor à haute mobilité d'électrons selon l'une des revendications 1 à 5, dans lequel la première couche barrière (16) et la deuxième couche barrière (12) comprennent un même matériau, ou dans lequel la première couche barrière (16) et la deuxième couche barrière (12) comprennent un même matériau avec des compositions d'alliage différentes, ou dans lequel la première couche barrière (16) et la deuxième couche barrière (12) comprennent des matériaux différents.

7. Transistor à haute mobilité d'électrons selon la revendication 3, dans lequel la deuxième couche barrière (12) est espacée de la structure de grille (14) par une structure d'espacement (26) comprenant le matériau diélectrique (28).

8. Transistor à haute mobilité d'électrons selon l'une des revendications 1 à 7, dans lequel la plaque de champ (36) est connectée à un contact de drain (34).

9. Transistor à haute mobilité d'électrons selon l'une des revendications 1 à 8, dans lequel la région plus épaisse (12a) de la première couche barrière (16) et de la deuxième couche barrière (12) se trouve dans la région de drain (18).

10. Transistor à haute mobilité d'électrons selon la revendication 9, dans lequel la première couche barrière (16) et la deuxième couche barrière (12) comprennent de l'AlGaN.

11. Procédé de fabrication d'un transistor à haute mobilité d'électrons, HEMT, le procédé comprenant :
la formation d'une structure de grille (14) et d'un métal de grille (30, 32) connecté à la structure de grille (14) ;
la formation d'une première couche barrière (16) au-dessous de et adjacente à la structure de grille (14) ;
la formation d'une deuxième couche barrière (12) au-dessus de la première couche barrière (16) et qui est située seulement dans des zones adjacentes à la structure de grille (14), dans lequel la première couche barrière (16) et la deuxième couche barrière (12) adjacente à la structure de grille (14) comprennent une région plus épaisse (12a) en comparaison avec la première couche barrière (16) au-dessous de la structure de grille (14) ; et
la formation d'une plaque de champ (36) au-dessus de la région plus épaisse (12a), dans lequel la plaque de champ (36) s'étend au-dessus de la structure de grille (14) et entoure le métal de grille (30, 32) et est isolée du métal de grille (30, 32) par une entretoise (33) sur des parois latérales verticales du métal de grille (30, 32).

12. Procédé selon la revendication 11, dans lequel la deuxième couche barrière (12) s'auto-aligne avec la structure de grille (14), et/ou dans lequel la plaque de champ (36) s'auto-aligne avec la structure de grille (14).
